# EUROPEAN PATENT SPECIFICATION

(11) **EP 3 063 786 B1**
(45) Date of publication and mention of the grant of the patent: **12.01.2022**
(21) Application number: 14798978.4
(22) Date of filing: 13.10.2014
(51) Int. Cl.: H01L 21/78

(54) **SCRIBING A WAFER OF SEMICONDUCTOR DEVICES**
ZERTEILUNG EINES WAFERS AUS HALBLEITERBAUELEMENTEN
DÉCOUPAGE D'UNE TRANCHE DE DISPOSITIFS À SEMI-CONDUCTEURS

(30) Priority: 29.10.2013 US 201361896842 P
(43) Date of publication of application: 07.09.2016
(73) Proprietor: Lumileds LLC, San Jose, CA 95131 (US)
(72) Inventor: PEDDADA, S. Rao, NL-5656 AE Eindhoven (NL); WEI, Frank Lili, NL-5656 AE Eindhoven (NL); CASAJE, Enrico, NL-5656 AE Eindhoven (NL); SHARMA, Rajat, NL-5656 AE Eindhoven (NL)
(74) Representative: ter Heegde, Paul Gerard Michel
(86) International application number: PCT/IB2014/065251
(87) International publication number: WO 2015/063633

(56) References cited:
- WO-A1-2005/062376
- US-A1- 2005 009 302
- US-A1- 2005 199 592
- US-A1- 2005 202 651
- US-A1- 2011 132 885
- US-B1- 8 399 281

## Description

### Field of the invention

The present invention relates to techniques for scribing a wafer of semiconductor light emitting devices formed on a transparent substrate.

### Background

Semiconductor light-emitting devices including light emitting diodes (LEDs), resonant cavity light emitting diodes (RCLEDs), vertical cavity laser diodes (VCSELs), and edge emitting lasers are among the most efficient light sources currently available. Materials systems currently of interest in the manufacture of high-brightness light emitting devices capable of operation across the visible spectrum include Group III-V semiconductors, particularly binary, ternary, and quaternary alloys of gallium, aluminum, indium, and nitrogen, also referred to as III-nitride materials. Typically, III-nitride light emitting devices are fabricated by epitaxially growing a stack of semiconductor layers of different compositions and dopant concentrations on a sapphire, silicon carbide, III-nitride, or other suitable substrate by metal-organic chemical vapor deposition (MOCVD), molecular beam epitaxy (MBE), or other epitaxial techniques. The stack often includes one or more n-type layers doped with, for example, Si, formed over the substrate, one or more light emitting layers in an active region formed over the n-type layer or layers, and one or more p-type layers doped with, for example, Mg, formed over the active region. Electrical contacts are formed on the n- and p-type regions.

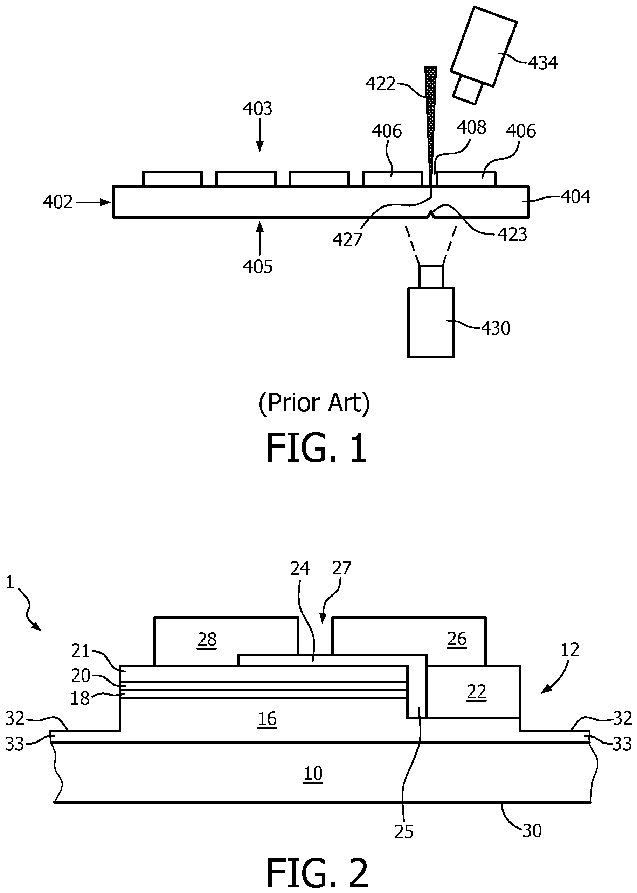

Individual devices or groups of devices are often separated from a wafer by scribing and breaking the wafer along streets between rows of devices. Fig. 1 illustrates a method of scribing a wafer, known as dual side scribing, described in more detail in US 2011/0132885. In Fig. 1, LEDs 406 are separated by streets 408. Cameras 430 and 434 are used on the front and back sides of the wafer to align the scribe line relative to the street 408. Paragraph 45 of US 2011/0132885 teaches "According to this method, a first shallow back side scribe 423 may be formed by ablation on the back side 405 of the wafer 402 .... A second front side scribe 427 may then be formed from the front side 403 of the wafer 402 by focusing the laser beam 422 internally within the substrate 404 of the wafer 402 and creating internal crystal damage (e.g. stealth or quasi-stealth scribing)." US 2005/199592 A1 describes a laser splitting method for splitting off a segment from an object to be split using a laser beam. The method includes a surface processing step of processing the object by forming a linear recessed portion in a surface of the object, the linear recessed portion being effective to cause a stress concentration at the surface of the object and an internal processed-region forming step of forming an internal processed-regions at a depth of the object.

### Summary

It is an object of the invention to provide a technique for scribing a wafer of semiconductor light emitting devices. The methods according to the invention are defined in independent claims 1 and 8. Preferred embodiments of the invention are defined by the dependent claims.

Embodiments of the invention include a method for separating a wafer including a growth substrate and a plurality of devices formed on the growth substrate and arranged in a plurality of rows separated by at least one street. The wafer includes a front side on which the plurality of devices are formed and a back side, which is a surface of the growth substrate. The method includes scribing a first scribe line aligned with the street on the front side, scribing a second scribe line aligned with the street on the back side, and scribing a third scribe line aligned with the street on the back side.

Embodiments of the invention include a method for separating a wafer including a growth substrate and a plurality of devices formed on the growth substrate and arranged in a plurality of rows separated by at least one street. The wafer includes a front side on which the plurality of devices are formed and a back side, which is a surface of the growth substrate. The method includes scribing a first scribe line aligned with the street on the front side and scribing a second scribe line aligned with the street on the back side. The growth substrate has a thickness greater than 100 microns. The street has a width less than 50 microns.

Embodiments of the invention include a method for separating a wafer including a growth substrate and a plurality of devices formed on the growth substrate and arranged in a plurality of rows separated by at least one street. The wafer has a front side on which the plurality of devices are formed and a back side, which is a surface of the growth substrate. The method includes scribing a first scribe line aligned with the street and scribing a second scribe line aligned with the street. The first and second scribe lines are both formed on the same side of the wafer.

### Brief description of the drawings

Fig. 1 illustrates a prior art scribing technique for a wafer of semiconductor devices.
Fig. 2 illustrates one example of a III-nitride LED.
Fig. 3 illustrates scribing a wafer of devices.

### Detailed description

In the technique illustrated in Fig. 1, shallow scribe lines are formed on the front and back side of the wafer. Since the scribe lines are shallow, the thickness of the substrate that can be scribed and broken with this technique with acceptable yield is limited. The hardness of typical substrate materials e.g. sapphire exacerbates this problem. The technique illustrated in Fig. 1 may be used to scribe and break devices with a growth substrate less than 90 µm thick, for example.

In some light emitting devices, it is desirable to leave a thick growth substrate attached to the light emitting device, for example to space a wavelength converting layer or other structure formed on the growth substrate apart from the light emitting layer of the device. Embodiments of the invention are directed to techniques for scribing and breaking a wafer of light emitting devices with a thick growth substrate.

Though in the examples below the semiconductor light emitting devices are III-nitride LEDs that emit blue or UV light, semiconductor light emitting devices besides LEDs such as laser diodes and semiconductor light emitting devices made from other materials systems such as other III-V materials, III-phosphide, III-arsenide, II-VI materials, ZnO, or Si-based materials may be used.

Fig. 2 illustrates a III-nitride LED that may be used in embodiments of the present invention. Any suitable semiconductor light emitting device may be used and embodiments of the invention are not limited to the device illustrated in Fig. 2. The device of Fig. 2 is formed by growing a III-nitride semiconductor structure 12 on a growth substrate 10 as is known in the art. The growth substrate is often sapphire but may be any suitable substrate such as, for example, SiC, Si, GaN, or a composite substrate. A surface of the growth substrate on which the III-nitride semiconductor structure is grown may be patterned, roughened, or textured before growth, which may improve light extraction from the device.

The semiconductor structure 12 includes a light emitting or active region sandwiched between n- and p-type regions. An n-type region 16 may be grown first and may include multiple layers of different compositions and dopant concentration including, for example, preparation layers such as buffer layers or nucleation layers, which may be n-type or not intentionally doped, and device layers that are not intentionally doped, n- or even p-type, designed for particular optical, material, or electrical properties desirable for the light emitting region to efficiently emit light. A light emitting or active region 18 is grown over the n-type region. Examples of suitable light emitting regions include a single thick or thin light emitting layer, or a multiple quantum well light emitting region including multiple thin or thick light emitting layers separated by barrier layers. A p-type region 20 may then be grown over the light emitting region. Like the n-type region, the p-type region may include multiple layers of different composition, thickness, and dopant concentration, including layers that are not intentionally doped, or n-type layers.

After growth, a p-contact is formed on the surface of the p-type region. The p-contact 21 often includes multiple conductive layers such as a reflective metal and a guard metal which may prevent or reduce electromigration of the reflective metal. The reflective metal is often silver but any suitable material or materials may be used. After forming the p-contact 21, a portion of the p-contact 21, the p-type region 20, and the active region 18 is removed to expose a portion of the n-type region 16 on which an n-contact 22 is formed. The n- and p-contacts 22 and 21 are electrically isolated from each other by a gap 25 which may be filled with a dielectric such as an oxide of silicon or any other suitable material. Multiple n-contact vias may be formed; the n- and p-contacts 22 and 21 are not limited to the arrangement illustrated in Fig. 2. The n- and p-contacts may be redistributed to form bond pads with a dielectric/metal stack, as is known in the art.

In order to form electrical connections to the LED, one or more interconnects 26 and 28 are formed on or electrically connected to the n- and p-contacts 22 and 21. Interconnect 26 is electrically connected to n-contact 22 in Fig. 2. Interconnect 28 is electrically connected to p-contact 21. Interconnects 26 and 28 are electrically isolated from the n- and p-contacts 22 and 21 and from each other by dielectric layer 24 and gap 27. Interconnects 26 and 28 may be, for example, solder, stud bumps, gold layers, or any other suitable structure.

Many individual LEDs are formed on a single wafer then diced from the wafer by scribing and breaking, as described below. The growth substrate is often thinned before scribing and breaking. The growth substrate may be thinned by any suitable technique including etching or mechanical techniques such as grinding, polishing, or lapping. After thinning, the growth substrate 10 may be at least 100 µm thick in some embodiments, at least 180 µm thick in some embodiments, at least 200 µm thick in some embodiments, no more than 360 µm thick in some embodiments, at least 220 µm thick in some embodiments, and no more than 260 µm thick in some embodiments. After thinning, the surface of the growth substrate opposite the growth surface (i.e. the surface through which a majority of light is extracted in a flip chip configuration) may be patterned, roughened or textured, which may improve light extraction from the device.

The device illustrated in Fig. 2 is separated from a wafer by scribing and breaking in streets 32 between individual devices on the wafer, as described below. In some embodiments, as illustrated in Fig. 2, some epitaxially grown material 33 remains in the street 32 between neighboring LEDs 1 (only a portion of each of the streets 32 on either side of LED 1 is illustrated in Fig. 2). For example, most of n-type region 16 may be etched away to reveal material 33 that is not intentionally doped and is substantially insulating. In some embodiments, in the streets 32, prior to scribing and breaking, the semiconductor structure is entirely removed to expose a surface of the growth substrate 10. After scribing and breaking to form individual devices or groups of devices, one or more structures such as a wavelength converting layer, a lens, or other optical structure, may be formed on the surface 30 of the growth substrate opposite the LED 1.

The individual LEDs including the epitaxially grown structure 12, the n- and p-contacts 22 and 21, and the interconnects 26 and 28 are represented in the following figure by block 1.

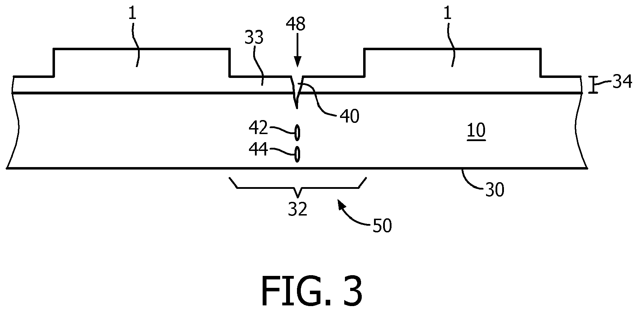

Fig. 3 illustrates a portion of a scribed wafer formed by methods according to embodiments of the invention. Fig. 3 illustrates two LEDs 1 separated by a street 32. The wafer illustrated in Fig. 3 has a front side 48 on which the LEDs 1 are disposed, and a back side 50, which is a surface of the growth substrate 10. The street 32 is scribed from the front side 48 to form at least one scribe line 40. Scribe line 40 may be formed by ablation scribing, a scribing technique that removes material along the scribed line to form a notch or opening along the scribed line. Ablation scribing may be performed by, for example, dry etching, mechanical scribing for example with a saw or diamond blade, or laser scribing. Laser scribing may be performed for example with a 266 nm or 355 nm diode pumped solid state laser. The laser beam may be pulsed or a continuous beam. Laser scribing tools are known in the art and commercially available.

The scribe line 40 formed on the front side 48 of the wafer extends through the entire thickness 34 of the semiconductor material 33 remaining in the street 32, which was epitaxially grown on the growth substrate as part of the semiconductor structure that forms the LEDs 1, and into growth substrate 10. The depth of the scribe line 40 in the growth substrate 10 is at least the thickness of material 33 in some embodiments and no more than three times the thickness of material 33 in some embodiments. The epitaxially grown material 33 is no more than 16 µm thick in some embodiments and no more than 8 µm thick in some embodiments.

The street 32 is also scribed from the back side 50 to form at least one scribe line. Two scribe lines 42 and 44 are illustrated in Fig. 3. Scribe lines 42 and 44 may be formed by stealth scribing in some embodiments. Stealth scribing is performed using, for example, a nanosecond infrared yttrium aluminum garnet laser. One or more lenses are used to focus the laser beam within the transparent sapphire substrate 10. The laser beam modifies the sapphire substrate to form a defected region which is more easily broken under mechanical loading than the surrounding, non-defected sapphire. Stealth scribing tools are known in the art and commercially available. In some embodiments, multiple stealth scribe lines, such as scribe lines 42 and 44, are formed during multiple "passes" with a stealth scribing tool, meaning the tool is scanned over the wafer multiple times. In some embodiments, multiple stealth scribe lines are formed during a single pass, where the tool is scanned over the wafer only once, by splitting the laser energy into two or more beams that are spatially separated to yield two or more defected regions at different depths.

The first back side scribe line 42 is located at a different depth within the growth substrate 10 than the second back side scribe line 44. The defected regions 42 and 44 may be at least 10 µm wide in some embodiments and no more than 50 µm wide in some embodiments. In some embodiments the defected regions 42 and 44 may be at least 20 µm and no more than 120 µm long. In some embodiments the shallow defected region 44 may be at least 10 µm and no more than 50 µm from the surface 30 of growth substrate 10. In some embodiments the deep defected region 42 may be at least 40 µm and no more than 120 µm from the surface 30 of growth substrate 10. The depth of scribe lines 42 and 44 relative to the surface 30 of growth substrate 10 may be selected by adjusting the optics on a commercially available stealth scribing tool.

In some embodiments, the shallow back side scribe line 44 may be formed by quasi-stealth scribing, where a portion of the scribe line at the surface 30 of substrate 10 is formed by laser ablation scribing and a portion of the scribe line within substrate 10 is formed by focusing the laser beam to form a defected region. In some embodiments, the shallow back side scribe line 44 may be formed by ablation scribing. Ablation scribing is described above in reference to front side scribe line 40.

The scribed lines 40, 42, and 44 may be formed in any order. In some embodiments, the front side scribe line 40 is formed first, then the wafer is flipped over and the back side scribe lines 42 and 44 are formed. In some embodiments, the back side scribe lines 42 and 44 are formed first, then the wafer is flipped over and the front side scribe line 40 is formed. The deeper back side scribe line 42 may be formed before shallower scribe line 44, or the shallower back side scribe line 44 may be formed before deeper scribe line 42.

In some embodiments, more than three scribe lines may be formed before breaking. Additional scribe lines may be formed on a thicker substrate as needed to facilitate breaking. In some embodiments, one or more additional back side scribe lines formed by stealth scribing at different depths may be added. In particular, fourth and fifth scribe lines may be formed by stealth scribing from the back side.

At least one of the scribe lines 42 is formed fairly deeply within the growth substrate, as compared to the shallow scribe lines described in Fig. 1. Accordingly, in the structure illustrated in Fig. 3, the street 32 may be broken fairly accurately, because the fracture propagates reliably along the multiple scribe lines 40, 42, and 44. Because the propagation of the fracture during breaking may be fairly well controlled, the street 32 in the device of Fig. 3 may be narrower than the streets required for breaking a thick substrate in the arrangement of Fig. 1, where only two shallow scribe lines are formed. In some embodiments, the street 32 is no more than 50 µm wide. In addition, because the substrate is weakened by multiple scribe lines in the breaking zone, less force may be required to break the substrate as compared to a substrate of the same thickness with only one or two scribe lines.

The front side and back side scribe lines are all aligned in substantially the same plane, for example using visual alignment as is known in the art.

In some embodiments, the front side scribe line 40 is omitted, and the wafer is broken after forming at least two scribe lines at different depths from the back side 50 of the wafer. In some embodiments, first, second, and third scribe lines are formed from the back side 50 of the wafer, for example using stealth scribing. One of the first, second, and third scribe lines is formed in an area close to the front side 48 surface of substrate 10, such that this scribe line effectively replaces front side scribe line 40. In some embodiments the scribe line formed closest to the front side surface of substrate 10 may be formed within 20 µm of the front side surface of substrate 10.

In some embodiments, the wafer is broken after forming at least two scribe lines at different depths from the front side 48 of the wafer, and the back side scribe lines are omitted. For example, the wafer may be broken after forming a front side ablation scribed line, and a front side stealth scribed line.

In a first example, the substrate is scribed with one front side scribe line and two back side scribe lines, as illustrated in Fig. 3. The substrate 10 is 240 microns thick, front side scribe 40 extends 6 microns into the substrate, back side scribe 42 is between depths 15 microns and 35 microns in the substrate, and back side scribe 44 is between depths 45 microns and 75 microns in the substrate.

In a second example, the substrate is scribed with one front side scribe line and four back side scribe lines. The substrate is 350 microns thick, the front side scribe extends 6 microns into the substrate, the first back side scribe (the back side scribe line closest to the front side 48 of the wafer) is between depths 15 microns and 35 microns in the substrate, the second back side scribe is between depths 45 microns and 75 microns in the substrate, the third back side scribe is between depths 80 and 110 microns in the substrate, and the fourth back side scribe (the back side scribe line closest to the back side 50 of the wafer) is between depths 115 and 150 microns on the substrate.

After the wafer is scribed as described above, the wafer may be broken along the scribe lines by a Guillotine-like die breaker, which is known in the art and commercially available. The wafer is placed on a support. A gap in the support is aligned with the scribe line to be broken. The wafer may be protected by a cover disposed between the wafer and the support. A breaker blade is aligned with the scribe line to be broken and a force is applied to a blade. The force on the blade causes fracture propagation between the scribed lines, resulting in separation.

Having described the invention in detail, those skilled in the art will appreciate that, given the present disclosure, modifications may be made to the invention without departing from the scope of the inventive concept described herein. The invention is defined by the appended claims.

## Claims

1. A method for separating a wafer (402) comprising a growth substrate (10) and a plurality of devices formed on the growth substrate (10) and arranged in at least two rows separated by at least one street(s) (32), the wafer comprising a front side (48) on which the plurality of devices are formed and a back side (50) comprising a surface of the growth substrate (10), the method comprising:
scribing a first scribe line aligned with a first street from the at least one street(s) (32) on the front side (48);
scribing a second scribe line aligned with the first street on the back side (50), comprising forming a first modified region within the growth substrate (10); and
scribing a third scribe line aligned with the first street on the back side (50),
wherein
scribing the third scribe line comprises forming a second modified region within the growth substrate (10); and
the first modified region is at a different depth in the growth substrate (10) than the second modified region.

2. The method of claim 1 wherein scribing a first scribe line comprises ablation scribing the first scribe line.

3. The method of claim 1 wherein:
the first street comprises material epitaxially grown on the growth substrate;
the first scribe line has a depth that extends into the growth substrate; and
the depth extending into the growth substrate is at least the thickness of the material epitaxially grown on the growth substrate.

4. The method of claim 1 wherein:
the first street comprises material epitaxially grown on the growth substrate;
the first scribe line has a depth that extends into the growth substrate; and
the depth extending into the growth substrate is no more than three times the thickness of the material epitaxially grown on the growth substrate.

5. The method of claim 1 wherein the growth substrate has a thickness greater than 200 microns.

6. The method of claim 1 wherein the first street has a width less than 50 microns.

7. The method of claim 1 further comprising scribing a fourth scribe line aligned with the first street on the back side, wherein scribing a fourth scribe line comprises forming a third modified region within the growth substrate, wherein the third modified region is at a different depth in the growth substrate than the first and second modified regions.

8. A method for separating a wafer (402) comprising a growth substrate (10) and a plurality of devices formed on the growth substrate (10) and arranged in a plurality of rows separated by at least one street(s) (32), the wafer (402) comprising a front side (48) on which the plurality of devices are formed and a back side (50) comprising a surface of the growth substrate (10), the method comprising:
scribing a first scribe line aligned with a first street from the at least one street(s) (32), comprising forming a first modified region within the growth substrate (10); ; and
scribing a second scribe line aligned with the first street,
wherein
scribing the second scribe line comprises forming a second modified region within the growth substrate (10);
the first modified region is at a different depth in the growth substrate (10) than the second modified region; and
the first and second scribe lines are both formed on the same side of the wafer (402).

9. The method of claim 8 wherein the first and second scribe lines are both formed on the back side of the wafer.

10. The method of claim 8 wherein the first scribe line is disposed over the second scribe line.

## Patentansprüche

1. Verfahren zum Vereinzeln eines Wafers (402), der ein Wachstumssubstrat (10) und eine Mehrzahl von Vorrichtungen aufweist, die auf dem Wachstumssubstrat (10) ausgebildet und in mindestens zwei Zeilen angeordnet ist, die durch mindestens einen Graben (32) getrennt sind, wobei der Wafer eine Vorderseite (48), auf welcher die Mehrzahl von Vorrichtungen ausgebildet ist, und eine Rückseite (50) aufweist, die eine Oberfläche des Wachstumssubstrats (10) aufweist, wobei das Verfahren aufweist:
Ritzen einer ersten Ritzlinie, die mit einem ersten Graben von dem mindestens einen Graben (32) ausgerichtet ist, auf der Vorderseite (48);
Ritzen einer zweiten Ritzlinie, die mit dem ersten Graben ausgerichtet ist, auf der Rückseite (50), aufweisend ein Bilden einer ersten modifizierten Region innerhalb des Wachstumssubstrats (10); und
Ritzen einer dritten Ritzlinie, die mit dem ersten Graben ausgerichtet ist, auf der Rückseite (50), wobei das Ritzen der dritten Ritzlinie ein Bilden einer zweiten modifizierten Region innerhalb des Wachstumssubstrats (10) aufweist; und
wobei die erste modifizierte Region in einer anderen Tiefe im Wachstumssubstrat (10) als die zweite modifizierte Region ist.

2. Verfahren nach Anspruch 1, wobei das Ritzen einer ersten Ritzlinie ein Ablationsritzen der ersten Ritzlinie aufweist.

3. Verfahren nach Anspruch 1, wobei:
der erste Graben Material aufweist, das epitaxial auf das Wachstumssubtrat aufgewachsen ist;
die erste Ritzlinie eine Tiefe aufweist, die sich in das Wachstumssubstrat erstreckt; und
die Tiefe, die sich in das Wachstumssubstrat erstreckt, mindestens die Dicke des epitaxial auf das Wachstumssubstrat aufgewachsenen Materials beträgt.

4. Verfahren nach Anspruch 1, wobei:
der erste Graben Material aufweist, das epitaxial auf das Wachstumssubtrat aufgewachsen ist;
die erste Ritzlinie eine Tiefe aufweist, die sich in das Wachstumssubstrat erstreckt; und
die Tiefe, die sich in das Wachstumssubstrat erstreckt, nicht mehr als dreimal die Dicke des epitaxial auf das Wachstumssubstrat aufgewachsenen Materials beträgt.

5. Verfahren nach Anspruch 1, wobei das Wachstumssubstrat eine Dicke aufweist, die größer als 200 Mikrometer ist.

6. Verfahren nach Anspruch 1, wobei der erste Graben eine Dicke von weniger als 50 Mikrometer aufweist.

7. Verfahren nach Anspruch 1, ferner aufweisend ein Ritzen einer vierten Ritzlinie, die mit dem ersten Graben ausgerichtet ist, auf der Rückseite, wobei das Ritzen der vierten Ritzlinie ein Bilden einer dritten modifizierten Region innerhalb des Wachstumssubstrats aufweist, wobei die dritte modifizierte Region in einer anderen Tiefe im Wachstumssubstrat als die erste und die zweite modifizierte Region ist.

8. Verfahren zum Vereinzeln eines Wafers (402), der ein Wachstumssubstrat (10) und eine Mehrzahl von Vorrichtungen aufweist, die auf dem Wachstumssubstrat (10) ausgebildet und in einer Mehrzahl von Zeilen angeordnet ist, die durch mindestens einen Graben (32) getrennt ist, wobei der Wafer (402) eine Vorderseite (48), auf welcher die Mehrzahl von Vorrichtungen ausgebildet ist, und eine Rückseite (50) aufweist, die eine Oberfläche des Wachstumssubstrats (10) aufweist, wobei das Verfahren aufweist:
Ritzen einer ersten Ritzlinie, die mit einem ersten Graben von dem mindestens einen Graben (32) ausgerichtet ist, aufweisend ein Bilden einer ersten modifizierten Region innerhalb des Wachstumssubstrats (10); und
Ritzen einer zweiten Ritzlinie, die mit dem ersten Graben ausgerichtet ist, wobei das Ritzen der zweiten Ritzlinie ein Bilden einer zweiten modifizierten Region innerhalb des Wachstumssubstrats (10) aufweist; und
wobei die erste modifizierte Region in einer anderen Tiefe im Wachstumssubstrat (10) als die zweite modifizierte Region ist; und
die erste und die zweite Ritzlinie beide auf der gleichen Seite des Wafers (402) gebildet werden.

9. Verfahren nach Anspruch 8, wobei die erste und die zweite Ritzlinie beide auf der Rückseite des Wafers gebildet werden.

10. Verfahren nach Anspruch 8, wobei die erste Ritzlinie über der zweiten Ritzlinie angeordnet wird.

## Revendications

1. Procédé de séparation d'une tranche (402) comprenant un substrat de développement (10) et une pluralité de dispositifs formés sur le substrat de développement (10) et disposés en au moins deux rangées séparées par au moins un méplat (32), la tranche comprenant une face avant (48) sur laquelle la pluralité de dispositifs est formée et une face arrière (50) comprenant une surface du substrat de développement (10), le procédé comprenant :
la gravure d'une première ligne de séparation alignée avec un premier méplat du au moins un méplat (32) sur la face avant (48) ;
la gravure d'une seconde ligne de séparation alignée avec le premier méplat sur la face arrière (50), comprenant la formation d'une première zone modifiée dans le substrat de développement (10) ; et
la gravure d'une troisième ligne de séparation alignée avec le premier méplat sur la face arrière (50), dans lequel
la gravure de la troisième ligne de séparation comprend la formation d'une seconde zone modifiée dans le substrat de développement (10) ; et
la première zone modifiée se trouve à une profondeur, dans le substrat de développement (10), différente de la seconde zone modifiée.

2. Procédé selon la revendication 1, dans lequel la gravure d'une première ligne de séparation comprend la gravure par ablation de la première ligne de séparation.

3. Procédé selon la revendication 1, dans lequel :
le premier méplat comprend un matériau développé de manière épitaxiale sur le substrat de développement ;
la première ligne de séparation possède une profondeur qui s'étend dans le substrat de développement ; et
la profondeur qui s'étend dans le substrat de développement est au moins l'épaisseur du matériau développé de manière épitaxiale sur le substrat de développement.

4. Procédé selon la revendication 1, dans lequel :
le premier méplat comprend un matériau développé de manière épitaxiale sur le substrat de développement ;
la première ligne de séparation possède une profondeur qui s'étend dans le substrat de développement ; et
la profondeur qui s'étend dans le substrat de développement est non supérieure à trois fois l'épaisseur du matériau développé de manière épitaxiale sur le substrat de développement.

5. Procédé selon la revendication 1, dans lequel le substrat de développement possède une épaisseur supérieure à 200 microns.

6. Procédé selon la revendication 1, dans lequel le premier méplat possède une largeur inférieure à 50 microns.

7. Procédé selon la revendication 1, comprenant en outre la gravure d'une quatrième ligne de séparation alignée avec le premier méplat sur la face arrière, dans lequel une quatrième ligne de séparation comprend la formation d'une troisième zone modifiée dans le substrat de développement, dans lequel la troisième zone modifiée se trouve à une profondeur, dans le substrat de développement, différente de la première et de la seconde zones modifiées.

8. Procédé de séparation d'une tranche (402) comprenant un substrat de développement (10) et une pluralité de dispositifs formés sur le substrat de développement (10) et disposés en une pluralité de rangées séparées par au moins un méplat (32), la tranche (402) comprenant une face avant (48) sur laquelle la pluralité de dispositifs est formée et une face arrière (50) comprenant une surface du substrat de développement (10), le procédé comprenant :
la gravure d'une première ligne de séparation alignée avec un premier méplat du au moins un méplat (32), comprenant la formation d'une première zone modifiée dans le substrat de développement (10) ; et
la gravure d'une seconde ligne de séparation alignée avec le premier méplat, dans lequel la gravure de la seconde ligne de séparation comprend la formation d'une seconde zone modifiée dans le substrat de développement (10) ;
la première zone modifiée se trouve à une profondeur, dans le substrat de développement (10), différente de la seconde zone modifiée ; et
la première et la seconde lignes de séparation sont formées sur la même face de la tranche (402).

9. Procédé selon la revendication 8, dans lequel la première et la seconde lignes de séparation sont formées sur la face arrière de la tranche.

10. Procédé selon la revendication 8, dans lequel la première ligne de séparation est disposée par-dessus la seconde ligne de séparation.
